# EUROPEAN PATENT APPLICATION

(11) **EP 4 696 996 A1**
(43) Date of publication of application: **18.02.2026**
(21) Application number: 25192861.0
(22) Date of filing: 30.07.2025
(51) Int. Cl.: G01H 9/00, H10P 72/00

(54) **SUBSTRATE PROCESSING APPARATUS, DETECTION METHOD, METHOD OF MANUFACTURING SEMICONDUCTOR DEVICE, AND RECORDING MEDIUM**

(30) Priority: 31.07.2024 JP 2024125046
(71) Applicant: Kokusai Electric Corporation, Tokyo 101-0045 (JP)
(72) Inventor: YONEDA, Akihiko, Toyama-shi, Toyama 9392393 (JP)
(74) Representative: Bardehle Pagenberg Partnerschaft mbB Patentanwälte Rechtsanwälte

(57) **Abstract**

A technique includes: a process chamber configured to process a substrate; a transferor configured to transfer the substrate; a component relating to at least one of the process chamber or the transferor; a memory storing a plurality of operation events; a plurality of areas in each of which at least one of the process chamber, the transferor, or the component is provided; a detector provided in at least one of the plurality of areas and configured to be capable of detecting an operating sound of the component; and a controller is configured to be capable of controlling the component and the detector to select one area of the plurality of areas, which corresponds to each of the plurality of operation events, and to acquire detection data from the detector provided in the selected one area.

## Description

### CROSS-REFERENCE TO RELATED APPLICATION

This application is based upon and claims the benefit of priority from Japanese Patent Application No. 2024-125046, filed on July 31, 2024, the entire contents of which are incorporated herein by reference.

### TECHNICAL FIELD

The present disclosure relates to a substrate processing apparatus, a detection method, a method of manufacturing a semiconductor device, and a non-transitory computer-readable recording medium storing a program.

### BACKGROUND

In the related art, there has been proposed a substrate processing apparatus for performing substrate processing in a semiconductor device manufacturing process. The substrate processing apparatus may detect a state of a component to perform maintenance such as a component replacement.

### SUMMARY

Some embodiments of the present disclosure provide a technique capable of easily detecting a state of a component.

According to one embodiment of the present disclosure, there is provided a technique that includes a process chamber configured to process a substrate; a transferor configured to transfer the substrate; a component relating to at least one of the process chamber or the transferor; a memory storing a plurality of operation events; a plurality of areas in each of which at least one of the process chamber, the transferor, or the component is provided; a detector provided in at least one of the plurality of areas and configured to be capable of detecting an operating sound of the component; and a controller is configured to be capable of controlling the component and the detector to select one area of the plurality of areas, which corresponds to each of the plurality of operation events, and to acquire detection data from the detector provided in the selected one area.

### BRIEF DESCRIPTION OF DRAWINGS

The accompanying drawings, which are incorporated in and constitute a part of the specification, illustrate embodiments of the present disclosure.
FIG. 1 is a vertical cross-sectional view entirely showing a schematic configuration of a substrate processing apparatus suitably used in one embodiment of the present disclosure.
FIG. 2 is a vertical cross-sectional view showing a process furnace of the substrate processing apparatus suitably used in one embodiment of the present disclosure and its surrounding.
FIG. 3 is a schematic diagram showing a portion in which a detector of the substrate processing apparatus suitably used in one embodiment of the present disclosure is provided.
FIG. 4 is a block diagram of a control system suitably used in one embodiment of the present disclosure.
FIG. 5 is a flowchart of a sound data storage process according to one embodiment of the present disclosure.

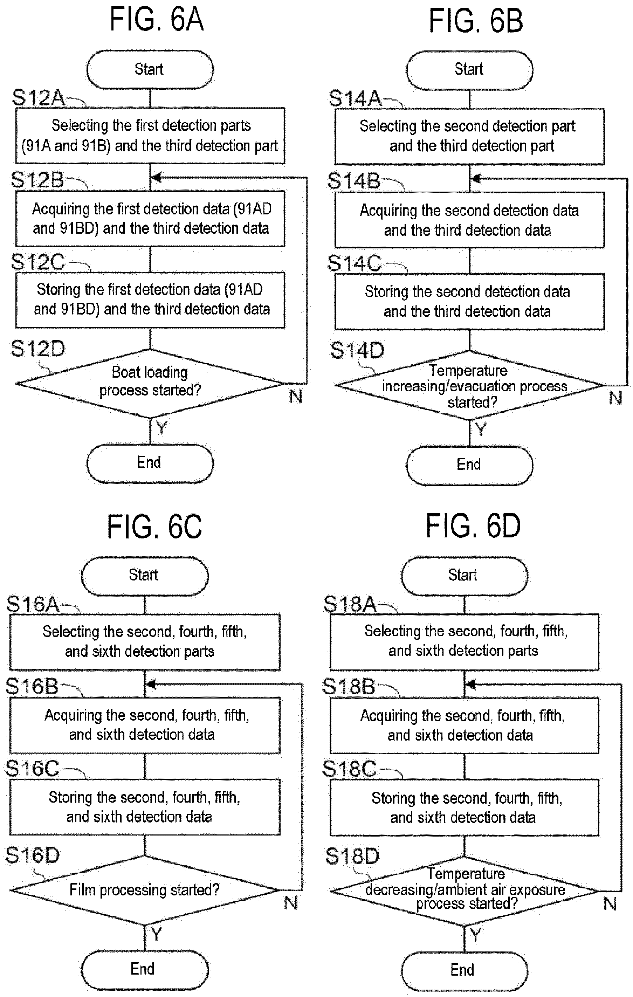

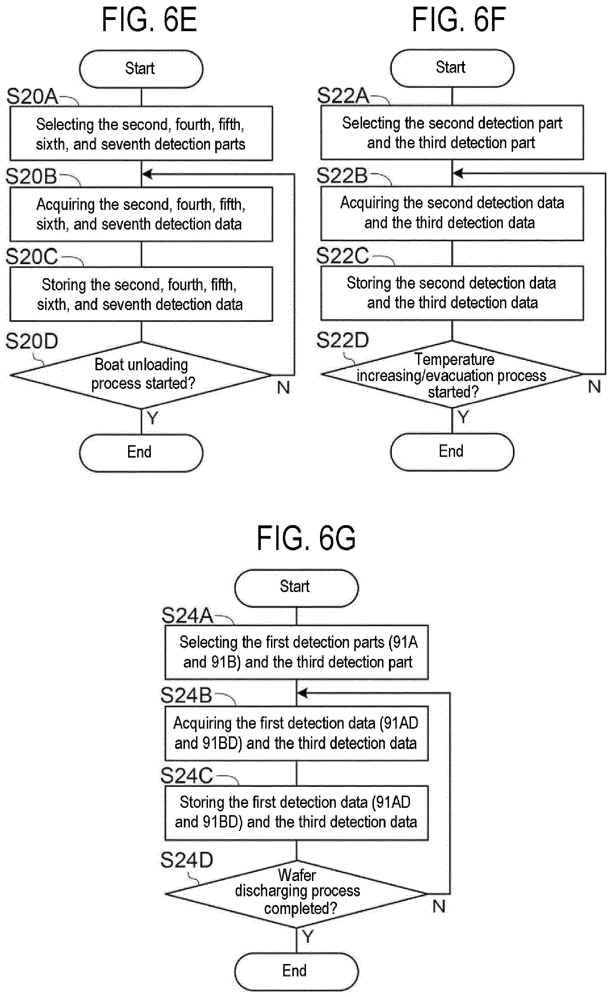

FIGS. 6A to 6G are flowcharts of processes in respective operation events of the sound data storage process according to one embodiment of the present disclosure, FIG. 6A being the flowchart of the sound data storage process in a wafer charging event according to one embodiment of the present disclosure, FIG. 6B being the flowchart of the sound data storage process in a boat loading event according to one embodiment of the present disclosure, FIG. 6C being the flowchart of the sound data storage process in a temperature elevation/evacuation event according to one embodiment of the present disclosure, FIG. 6D being the flowchart of the sound data storage process in a film processing event according to one embodiment of the present disclosure, FIG. 6E being the flowchart of the sound data storage process in a temperature reduction/atmospheric exposure event according to one embodiment of the present disclosure, FIG. 6F being the flowchart of the sound data storage process in a temperature reduction/boat unloading event according to one embodiment of the present disclosure, and FIG. 6G being the flowchart of the sound data storage process in a temperature reduction/wafer discharging event according to one embodiment of the present disclosure.
FIG. 7 is a tabulated list showing main sound sources, detection targets, and reference sound data in each event according to one embodiment of the present disclosure.
FIG. 8 is a flowchart of an abnormal sound check process according to one embodiment of the present disclosure.
FIG. 9 is a horizontal cross-sectional view entirely showing a schematic configuration of a substrate processing apparatus according to a modification of the present disclosure.
FIG. 10 is a vertical cross-sectional view entirely showing the schematic configuration of the substrate processing apparatus according to the modification of the present disclosure.

### DETAILED DESCRIPTION

Hereinafter, one embodiment of the present disclosure will be described with reference to the drawings. The drawings used in the following description are schematic, and relationships between dimensions of respective elements, ratios of the respective elements, and the like used in the drawings may differ from reality. Also, there may be a case where relationships of dimensions and ratios of respective elements differ from each other between the drawings.

### (1) Configuration of Substrate Processing Apparatus

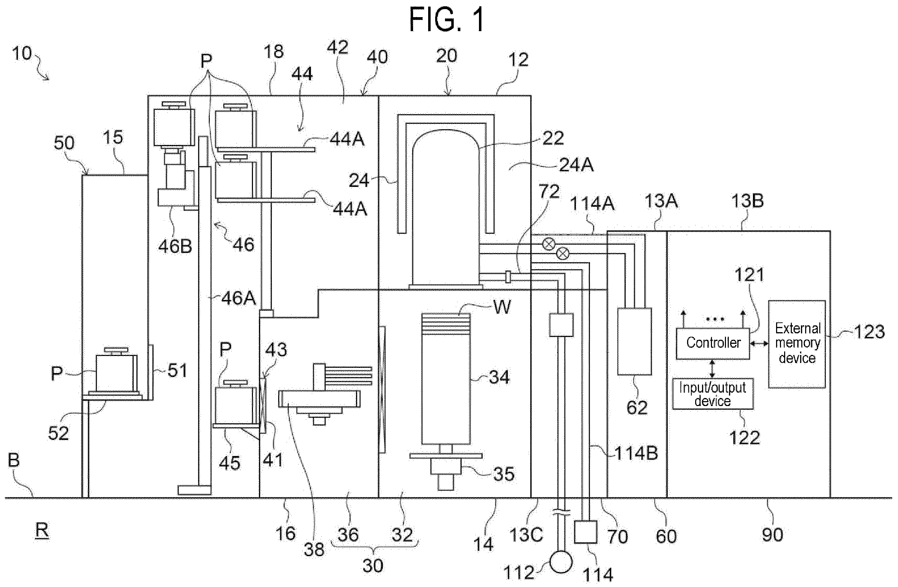

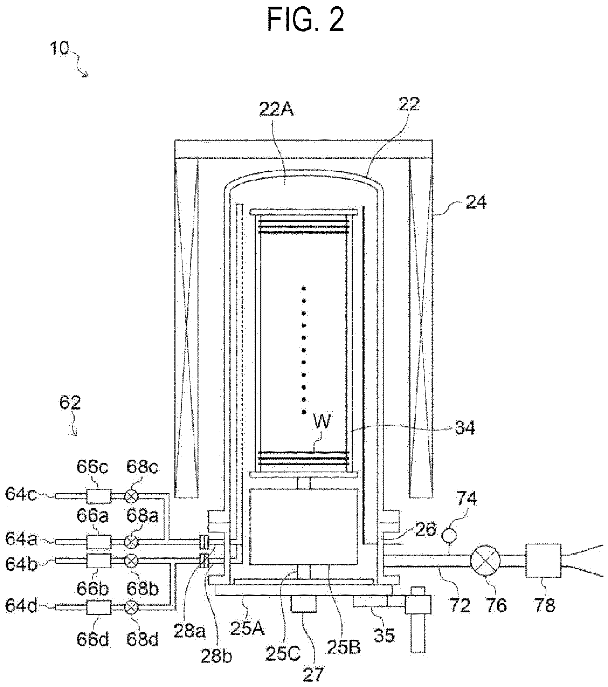

A substrate processing apparatus 10 is configured as a vertical substrate processing apparatus that performs a substrate processing process such as a heat treatment or the like as one of processes of manufacturing a semiconductor device. As shown in FIGS. 1 and 2, the substrate processing apparatus 10 includes a processing module 20, a processing transfer section 30, a transfer section 40, and a container loading/unloading section 50. These are arranged in the order of the container loading/unloading section 50, the transfer section 40, and the processing transfer section 30, as viewed from a front side of the substrate processing apparatus 10. The processing module 20 is arranged above the processing transfer section 30.

The processing module 20 is defined in a main housing 12. A reaction tube 22 and a heater 24 are provided inside the processing module 20. The reaction tube 22 is formed in a substantially cylindrical shape with a closed upper end. A heater 24 is arranged on an outer periphery of the reaction tube 22. A flow path 24A is provided around the heater 24 to form a gas flow of an inert gas that suppresses excessive heating of the heater 24. The flow path 24A is in communication with a gas supply pipe 114A capable of supplying the inert gas and an exhaust pipe 114B capable of exhausting the inert gas. The reaction tube 22 is formed of, for example, quartz or silicon carbide (SiC). Inside the reaction tube 22, a process chamber 22A for processing a wafer W as a substrate is formed. An internal space of the processing module 20 as a first processing area is defined by the main housing 12, and is configured as an independent closed space which is independent of housings 14 and 16 to be described later. Similarly, each of the housings 14 and 16 is partitioned from the main housing 12. Internal spaces of the housings 14 and 16 are configured as different closed spaces.

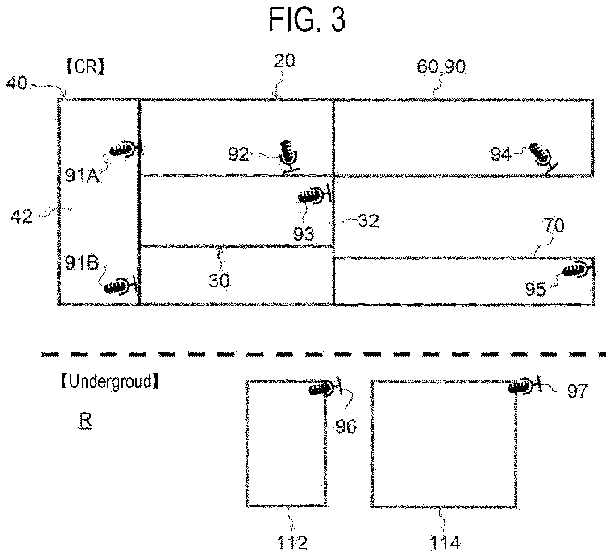

As shown in FIG. 3, a second detector 92 is provided inside the main housing 12. The second detector 92 detects operation sound generated inside the main housing 12. Data detected by the second detector 92 will be referred to as "second detection data 92D."

A transfer chamber 32 and a transfer chamber 36 of the processing transfer section 30 are provided below the processing module 20. In the transfer chamber 32, there are provided a boat 34 which supports a plurality of wafers W and a boat elevator 35 which is capable of raising and lowering the boat 34. The boat elevator 35 may be sometimes referred to as a boat lifter. The wafers W are transferred to the boat 34 inside the transfer chamber 32. The transfer chamber 36 is arranged to be adjacent to a front side of the transfer chamber 32. In the transfer chamber 36, there is provided a transfer machine 38 which delivers the wafers W. The transfer chamber 32 and the transfer chamber 36 are configured as independent spaces defined by the housing 14 and the housing 16, respectively. An opening (not shown) is provided between the housing 16 and a housing 18 described later. The wafers W may be moved via the opening. A pod opener 43 is provided on the side of the housing 16 in the opening. The pod opener 43 includes a cap opening/closing mechanism 41. A cap of a pod P is opened and closed by the cap opening/closing mechanism 41. The transfer chamber 32 and the transfer chamber 36 constitute a third area. In this embodiment, the third area may be referred to as a third transfer area. At least one of the boat elevator 35 or the transfer machine 38, or both, may be collectively referred to as a second transferor.

As shown in FIG. 3, a third detector 93 is provided in the transfer chamber 32. The third detector 93 detects operation sound generated inside the transfer chamber 32. Data detected by the third detector 93 will be referred to as "third detection data 93D."

The transfer section 40 is arranged in front of the processing module 20 and the transfer chamber 36. In the transfer section 40, there are provided a shelf 44 that stores the pod P as a container for accommodating the wafers W, a stage 45 on which the pod P is placed, and a carrier loader 46 as a first transferor. The shelf 44 includes a shelf plate 44A, and the container is held by the shelf plate 44A. The carrier loader 46 includes an elevator 46A (container elevator) as a lifter for raising and lowering the pod P, and a pod transfer mechanism 46B for transferring the pod P between the transfer section 40 and the container loading/unloading section 50 described later. A transfer chamber 42 having an independent space defined by the housing 18 is provided inside the transfer section 40.

As shown in FIG. 3, first detectors 91A and 91B are provided in the transfer chamber 42. The first detector 91A is provided in an upper portion of the transfer chamber 42, and the first detector 91B is provided below the first detector 91A. The first detectors 91A and 91B detect operating sounds generated inside the transfer chamber 42. Data (information) detected by the first detectors 91A and 91B will be referred to as "first detection data 91AD" and "first detection data 91BD," respectively. The first detector 91A may also be referred to as a first sub-detector, and the first detector 91B may also be referred to as a second sub-detector. The first and second sub-detectors may be collectively referred to as a first detector.

An interior of the container loading/unloading section 50 is configured as an independent space defined by the housing 15. An opening (not shown) through which access from the outside to the housing 15 is possible is provided in the housing 15. A load port 52 is provided in the container loading/unloading section 50. The pod P is loaded onto the load port 52 via the opening by a transfer device (not shown) provided outside the substrate processing apparatus 10, and is unloaded from the load port 52 via the opening. An opening (not shown) that is opened and closed by a front shutter 51 is provided between the housing 15 and the housing 18. The pod P is moved between the housing 15 and the housing 18 via the opening. An area in which the transfer section 40 is provided is configured as a second area. The second area may be referred to as a second transfer area. The second area and the third area are partitioned by different housings. Each of the housings has a closed space.

As shown in FIG. 2, gases used for substrate processing are supplied into the process chamber 22A by a gas supply mechanism 62 serving as a supply control system. The gas supply mechanism 62 is accommodated in a supply box 60 serving as a second processing area. An independent closed space defined by a housing 13A is formed inside the supply box 60. The gas supply mechanism 62 may include a gas supply pipe 114A.

The gas supply mechanism 62 includes gas supply pipes 64a and 64b, and inert gas supply pipes 64c and 64d. Mass flow controllers (hereinafter, referred to as MFCs) 66a and 66b, which are flow rate controllers, and valves 68a and 68b, which are opening/closing valves, are provided in the gas supply pipes 64a and 64b sequentially from upstream sides, respectively. The gas supply pipe 64a is connected to a nozzle 28a penetrating a sidewall of a manifold 26, which will be described later. The gas supply pipe 64b is connected to a nozzle 28b penetrating the sidewall of the manifold 26. The nozzles 28a and 28b are provided upright along the vertical direction inside the reaction tube 22. Each of the nozzles 28a and 28b has a plurality of supply holes open toward the wafers W held by the boat 34. As an example, a raw material gas is supplied toward the wafers W via the supply holes of the nozzle 28a, and a reaction gas is supplied toward the wafers W via the supply holes of the nozzle 28b.

MFCs 66c and 66d and valves 68c and 68d are respectively provided in the inert gas supply pipes 64c and 64d sequentially from upstream sides. The inert gas supply pipe 64c is connected to the nozzle 28a, and the inert gas supply pipe 64d is connected to the nozzle 28b. An inert gas is supplied to the wafers W from the inert gas supply pipes 64c and 64d. Either or both of the raw material gas and the reaction gas may be collectively referred to as a processing gas. The inert gas may be included in the processing gas.

As shown in FIG. 3, a fourth detector 94 is provided inside the supply box 60. The fourth detector 94 detects operation sound generated inside the supply box 60. Data detected by the fourth detector 94 will be referred to as "fourth detection data 94D."

As shown in FIG. 2, a cylindrical manifold 26 is connected to a lower end opening of the reaction tube 22 via a sealing member such as an O-ring or the like to support a lower end of the reaction tube 22. The lower end opening of the manifold 26 is opened and closed by a disk-shaped seal cap 25A. A sealing member such as an O-ring or the like is provided on an upper surface of the seal cap 25A so that the interior of the reaction tube 22 is air-tightly sealed with respect to ambient air. A heat insulator 25B is placed on the seal cap 25A.

An exhaust pipe 72 is attached to the manifold 26. A vacuum pump 78 as an evacuation device is connected to the exhaust pipe 72 via a pressure sensor 74 as a pressure detector that detects an internal pressure of the process chamber 22A, and an auto pressure controller (APC) valve 76 as a pressure regulator. With this configuration, the internal pressure of the process chamber 22A may be regulated to a processing pressure adapted for processing. An exhaust control system is mainly composed of the exhaust pipe 72 and the APC valve 76. The exhaust control system is accommodated in the exhaust box 70 as a third processing area. An independent closed space defined by a housing 13C is formed inside the exhaust box 70.

The processing module 20, the supply box 60, and the exhaust box 70 constitute a first area.

As shown in FIG. 3, a fifth detector 95 is provided inside the exhaust box 70. The fifth detector 95 detects operation sound generated inside the exhaust box 70. Data detected by the fifth detector 95 will be referred to as "fifth detection data 95D."

The process chamber 22A may accommodate therein a boat 34 which supports the plurality of wafers W, for example, 25 to 150 wafers W. The boat 34 is configured to support the wafers W in a horizontal posture in multiple stages in a vertically aligned state with their centers aligned with each other, that is, to arrange the wafers W at intervals. The boat 34 is made of a heat-resistant material such as quartz or SiC. The boat 34 is supported above the heat insulator 25B by a rotary shaft 25C that penetrates the seal cap 25A and the heat insulator 25B. The rotary shaft 25C is connected to a rotation mechanism 27 provided below the seal cap 25A. The rotary shaft 25C is configured to be rotatable while hermetically sealing the interior of the reaction tube 22. The seal cap 25A is driven in a vertical direction by the boat elevator 35. As a result, the boat 34 and the seal cap 25A are raised and lowered together so that the boat 34 is loaded into and unloaded from the reaction tube 22.

The main housing 12, the housing 13A, the housing 13B, the housing 13C, the housing 14, the housing 15, the housing 16, and the housing 18 which accommodate respective parts are supported on a floor B. An underground space R is formed below the floor B. A pump 112 and a blower box 114 are provided in the underground space R. A fan that may control an ambient atmosphere of the heater 24 is provided inside the blower box 114. An exhaust pipe 114B is connected to the blower box 114. The pump 112 is connected to the exhaust pipe 72. The pump 112 exhausts a gas in the process chamber 22A. A sixth detector 96 is provided near the pump 112 in the underground space R. A seventh detector 97 is provided in the blower box 114. The sixth detector 96 detects operation sound generated inside the underground space R. The seventh detector 97 detects the operation sound generated inside the blower box 114. Data detected by the sixth detector 96 will be referred to as "sixth detection data 96D," and data detected by the seventh detector 97 will be referred to as "seventh detection data 97D."

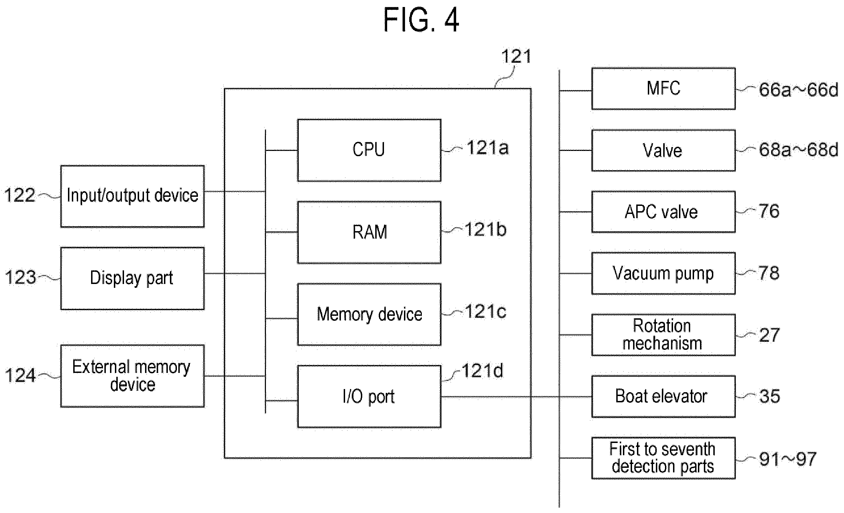

As shown in FIG. 4, a controller 121, which is a controller, is configured as a computer including a central processing unit (CPU) 121a, a random access memory (RAM) 121b, a memory device 121c, and an I/O port 121d. The RAM 121b, the memory device 121c, and the I/O port 121d are configured to be able to exchange data with the CPU 121a via an internal bus 121e. An input/output device 122 configured as, for example, a touch panel, and a display 123 are connected to the controller 121.

The memory device 121c as a memory may include a flash memory, a hard disk drive (HDD), or the like. A control program for controlling the operation of the substrate processing apparatus, a process recipe in which procedures and conditions of the substrate processing described later are written, and the like are readably stored in the memory device 121c. The process recipe is a combination that causes the controller 121 to execute respective procedures in the substrate processing described later so as to obtain a predetermined result, and functions as a program. Hereinafter, the process recipe, the control program, and the like may be simply collectively referred to as a program (program product). In addition, the process recipe may be simply referred to as a recipe. When the term "program" is used in this specification, it may refer to the recipe alone, the control program alone, or both. The RAM 121b is configured as a memory area (work area) in which the programs and data read by the CPU 121a are temporarily held.

The I/O port 121d is connected to the above-mentioned MFCs 66a to 66d, valves 68a to 68d, APC valve 76, vacuum pump 78, rotation mechanism 27, boat elevator 35, first detectors 91A and 91B, second detector 92, third detector 93, fourth detector 94, fifth detector 95, sixth detector 96, seventh detector 97, and the like. The pieces of data detected by the first detectors 91A and 91B, the second detector 92, the third detector 93, the fourth detector 94, the fifth detector 95, the sixth detector 96, and the seventh detector 97 pass through a filter configured to pass only a wavelength of a predetermined width therethrough. This eliminates a need for the controller 121 to execute discrimination processing such as noise removal or the like.

The CPU 121a is configured to read the control program from the memory device 121c and execute the same, and is also configured to read a recipe from the memory device 121c in response to an operation command input by the input/output device 122. The CPU 121a is configured to, according to the contents of the read recipe, control the operation of adjusting flow rates of various gases by the MFCs 66a to 66d, the opening/closing operation by the valves 68a to 68d, the opening/closing operation by the APC valve 76, the start and stop of the operation of the vacuum pump 78, an operation of adjusting the rotation and rotation speed of the boat 34 by the rotation mechanism 27, an operation of raising and lowering the boat 34 by the boat elevator 35, and the like.

The controller 121 may be configured to install the above-mentioned program stored in an external memory device (for example, a magnetic disk such as a hard disk, an optical disk such as a CD, or a semiconductor memory such as a USB memory) 124 in the computer. The memory device 121c and the external memory device 124 are configured as a non-transitory computer-readable recording media. Hereinafter, these may be simply collectively referred to as a recording medium. When the term "recording medium" is used in this specification, it may include the memory device 121c alone, the external memory device 124 alone, or both. The program may be provided to the computer using a communication means such as the Internet or a dedicated line without using the external memory device 124.

The controller 100 is accommodated in a controller box 90. An independent space defined by the housing 13B is formed inside the controller box 90. Instead of being provided inside the supply box 60, the fourth detector 94 may be provided inside the controller box 90 to detect operation sound generated inside the controller box 90.

Next, reference sound data stored in advance in the memory device 121c or the external memory device 123 will be described.

Reference sound data D is data of normal sound patterns corresponding to the pieces of detection data detected by the first detectors 91A and 91B, the second detector 92, the third detector 93, the fourth detector 94, the fifth detector 95, the sixth detector 96, and the seventh detector 97 during respective operation events described below when the respective parts of the substrate processing apparatus 10 are operating normally.

In a case in which there are multiple detection targets for each operation event, the reference sound data D is stored as a pattern obtained by integrating plural pieces of detection data. For example, the reference sound data D for a wafer charging event is a pattern obtained by integrating pieces of detection data detected by the first detectors 91A and 91B and the third detector 93 when the respective parts of the substrate processing apparatus are operating normally. The pattern thus integrated is also referred to as a normal sound feature pattern. In addition, in each operation event, the pattern is stored as data accompanied by a time series of processing. The reference sound data D is compared with actual detection data detected during an actual operation. When a difference between the reference sound data D and the actual detection data exceeds a predetermined threshold value TH, an abnormality is determined to occur.

When a plurality of detectors is provided in the same area, the reference sound data D is stored as a pattern obtained by integrating pieces of data detected by the plurality of detectors. For example, a pattern obtained by integrating pieces of data detected by the first detectors 91A and 91B in the second area is stored as the reference sound data D. As used herein, the expression "a plurality of detectors is used in one area" may refer to a case of detecting operating states of components arranged at different locations even in one area, or a case of detecting operating states of a plurality of components arranged close to each other to generate different operating sounds. For example, in the second area, the first detector 91A detects sound in an area above the elevator 46A and operating sound of the shelf 44, and the first detector 91B detects sound in an area below the elevator 46A and operating sound of the front shutter 51.

The reference sound data D may be stored for each operation type. Further, an operation event may be set for each operation type of the apparatus. Examples of the operation types include an operation for each type of substrate processing, an operation in the presence or absence of the substrate in the process chamber, an operation for each type of substrate, an operation for each state of the substrate, an operation for initial setting of the apparatus, an operation during maintenance of the apparatus, and the like.

Next, a specific example of the operation type will be described. The substrate processing includes, for example, a cycle process in which gases are alternately supplied to the process chamber, a chemical vapor deposition (CVD) process in which gases are simultaneously supplied to the process chamber, and the like. It is considered that the operating conditions of components differ between the cycle process and the CVD process, for example, in terms of the opening/closing timing and frequency of valves. Therefore, it is desirable to provide reference sound data for each type of substrate processing.

The states in the presence or absence of the substrate in the process chamber will be described. The state in the presence of the substrate in the process chamber refers to, for example, a state in which a cycle process, a CVD process, or the like is performed on the substrate W while the substrate W is present inside the process chamber. The state in the absence of the substrate in the process chamber refers to, for example, a state in which a cleaning process for cleaning an inner wall of the process chamber, or a seasoning process or conditioning process for processing the inner wall of the process chamber before performing the substrate processing is performed in the absence of the substrate W in the process chamber. Since the operations of the valves and the pumps may differ in the presence of the substrate and the absence of the substrate, the reference sound data may be set for each operation in the presence of the substrate and the absence of the substrate. Further, in this case, the reference sound data may be set for each process such as the cleaning process, the seasoning process, and the conditioning process.

The types of substrates will be described. There are types of substrates with different sizes and shapes, such as a 300 mm substrate and a 200 mm substrate, and types of substrates with different materials, such as a silicon substrate and a SiC (silicon carbide) substrate. For each type of substrate, operating conditions of the components, for example, an ascending/descending speed of the elevator and a rotation speed of the transfer machine may differ from each other. For this reason, it is desirable to provide reference sound data for each type of substrate.

The states of the substrate will be described. The states of the substrate may include, for example, a state before the substrate processing and a state after the substrate processing. The state before the substrate processing may be, for example, a state before the substrate is subjected to a heat treatment. The state after the substrate processing may be, for example, a state after the substrate is subjected to the heat treatment.

In addition, there may be a state in which many types of films are formed on the substrate, and a state in which a few types of films are formed on the substrate. In these cases, stresses to all the films formed on the substrate may differ from each other. For each of these substrate states, it is considered that the operating states of the components, for example, the ascending/descending speed of the elevator and the rotation speed of the transfer machine may differ from each other. Therefore, it is desirable to provide reference sound data adapted for each substrate state.

An initial setting of the apparatus will be described. In the initial setting of the apparatus, for example, a teaching operation of a transfer robot may be performed. In this case, it is considered that an operation speed of the transfer robot is set slower than that during the substrate processing. Thus, it is desirable to provide reference sound data for the initial setting of the apparatus. More preferably, for example, reference sound may be provided for each event during the initial setting.

Maintenance of the apparatus will be described. During the maintenance of the apparatus, for example, the maintenance of a transfer robot or an elevator may be performed. In this case, it is considered that the operation speed of the elevator or the transfer robot is slower than that during the substrate processing. Thus, it is desirable to provide reference sound data during the maintenance of the apparatus. More preferably, for example, reference sound may be provided for each event during the maintenance.

Data learned by machine learning may be used as the reference sound data D. The data learned by the machine learning is, for example, data in consideration of a usage time, usage frequency, deterioration, or the like of a component. In other words, the reference sound data D may be produced by machine-learning information about the usage frequency of the component and information about the deterioration of the condition of the component.

Next, a substrate processing method using the substrate processing apparatus 10 will be described. This substrate processing method is a method of manufacturing a semiconductor device. Thus, the substrate processing method may also be referred to as a semiconductor device manufacturing method. The CPU 121a of the controller 121 reads the program stored in the memory device 121c in the RAM 121b, and executes control for the operation events such as wafer charging, boat loading, temperature elevation, evacuation, film formation, temperature reduction, atmospheric pressure restoring, boat unloading, and wafer discharging based on the recipe. Each part of the substrate processing apparatus 10 operates based on control signals from the CPU 121a. At the same time, the CPU 121a executes a sound data storage process for each operation event. That is, a process of switching a sound detection target is executed for each operation event. This process may be a process of selecting at least one area from a plurality of areas in which a sound detection operation is performed to correspond to each of the plurality of operation events.

### (Wafer Charging)

The pod P accommodating the wafers W therein is loaded onto the load port 52 of the container loading/unloading section 50 via the opening formed in the housing 15. When the front shutter 51 is open, the carrier loader 46 moves the pod P into the transfer section 40 and transfers the same to a specified shelf 44. Further, the carrier loader 46 directly moves the pod P stored on the shelf 44 or the pod P loaded from the load port 52 to the stage 45.

A door (not shown) of the pod P on the stage 45 is removed by the cap opening/closing mechanism 41, and the wafers W inside the pod P are taken out by the transfer machine 38 and transferred to the boat 34. During the wafer charging, the transfer machine 38 and the carrier loader 46 become components serving as main sound sources.

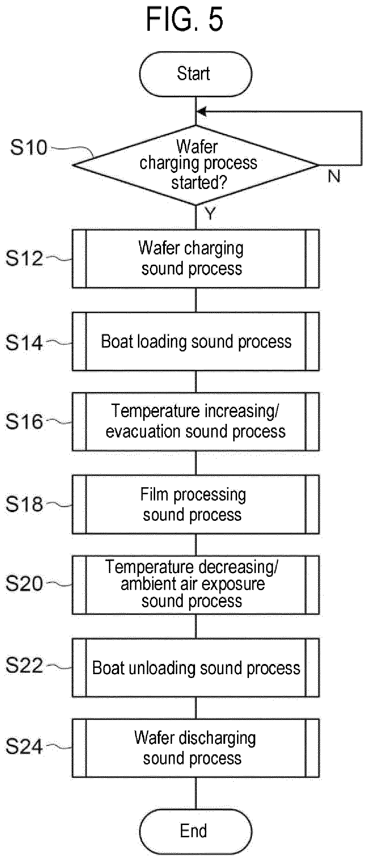

As shown in FIG. 5, during the wafer charging process in which the wafers W are transferred from the load port 52 to the boat 34, in the sound data storage process, when it is determined in Operation S10 that the wafer charging process has started, a wafer charging sound process is executed in Operation S12. In the wafer charging sound process, as shown in FIG. 6A, in Operation S12A, the first detector 91A, the first detector 91B, and the third detector 93 are selected as detection targets. Thus, only the first detector 91A, the first detector 91B, and the third detector 93 are instructed to detect operation sound. In Operation S12B, the controller 121 acquires (receives) the first detection data 91AD, the first detection data 91BD, and the third detection data 93D. In Operation S12C, the controller 121 stores the first detection data 91AD, the first detection data 91BD, and the third detection data 93D in the memory device 121c together with detection times. In Operation S12D, it is determined whether or not the boat loading process has started. When the result of the determination is NO, the process returns to Operation S12B to repeat the above processes. In this way, the first detection data 91AD, the first detection data 91BD, and the third detection data 93D are stored in the memory device 121c together with the detection times until the wafer charging process is completed.

### (Boat Loading)

After a pre-specified number of wafers W are charged to the boat 34, a lower end of the reaction tube 22, which has been closed by a furnace throat shutter (not shown), is opened. The boat 34 that holds the group of wafers W is lifted by the boat elevator 35 and loaded into the process chamber 22A inside the reaction tube 22. After the boat 34 is loaded, the process chamber 22A is air-tightly closed by the seal cap 25A. During the boat loading, the boat elevator 35 and the seal cap 25A (furnace throat seal cap) become components serving as main sound sources.

In the sound data storage process, when it is determined in Operation S12D that the boat loading process has started, a boat loading sound process is started in Operation S14. In the boat loading sound process, as shown in FIG. 6B, the second detector 92 and the third detector 93 are selected as detection targets in Operation S14A. Thus, only the second detector 92 and the third detector 93 are instructed to detect operation sound. In Operation S14B, the controller 121 acquires the second detection data 92D and the third detection data 93D, and in Operation S14C, stores the second detection data 92D and the third detection data 93D in the memory device 121c together with detection times. In Operation S14D, it is determined whether or not the temperature elevation process and the evacuation process have started. When the result of the determination is NO, the process returns to Operation S14B to repeat the above processes. In this way, the second detection data 92D and the third detection data 93D are stored in the memory device 121c together with the detection times until the boat loading process is completed.

### (Temperature elevation and Evacuation)

After the boat loading process, an internal atmosphere of the reaction tube 22 is heated to a predetermined temperature by the heater 24, and the interior of the reaction tube 22 is evacuated to a predetermined pressure by the operations of the vacuum pump 78 and the pump 112. During the temperature elevation and evacuation, the vacuum pump 78 and the pump 112 become components serving as main sound sources.

In the sound data storage process, when it is determined in Operation S14D that the boat loading process has started, a temperature elevation/evacuation sound process is started in Operation S16. In the temperature elevation/evacuation sound process, as shown in FIG. 6C, the second detector 92, the fourth detector 94, the fifth detector 95, and the sixth detector 96 are selected as detection targets in Operation S16A. Thus, only the second detector 92, the fourth detector 94, the fifth detector 95, and the sixth detector 96 are instructed to detect operation sound. In Operation S16B, the second detection data 92D, the fourth detection data 94D, the fifth detection data 95D, and the sixth detection data 96D are acquired, and in Operation S16C, the second detection data 92D, the fourth detection data 94D, the fifth detection data 95D, and the sixth detection data 96D are stored in the memory device 121c together with detection times. In Operation S16D, it is determined whether or not a film formation process has started. When the result of the determination is NO, the process returns to Operation S16B to repeat the above processes. In this way, the second detection data 92D, the fourth detection data 94D, the fifth detection data 95D, and the sixth detection data 96D are stored in the memory device 121c together with the detection times until the temperature elevation/evacuation process is completed.

### (Film Processing)

When predetermined conditions for the internal temperature and internal pressure of the reaction tube 22 are satisfied, the boat 34 is rotated by the rotation mechanism 27, and the processing gas is introduced into the process chamber 22A from the nozzles 28a and 28b via the gas supply pipes 64a and 64b in a predetermined procedure. The introduced processing gas passes through the process chamber 22A and is exhausted from the exhaust pipe 72. The processing gas comes into contact with the surface of the wafer W as it passes through the process chamber 22A. At this time, film processing such as film formation or film modification is performed on the surface of the wafer W. In the film processing, respective parts of the gas supply mechanism 62 (for example, the supply pipes and the valves) become components serving as main sound sources.

In the sound data storage process, when it is determined in Operation S16D that the film processing has started, a process of collecting sound during the film processing is started in Operation S18. In the collection process, as shown in FIG. 6D, in Operation S18A, the second detector 92, the fourth detector 94, the fifth detector 95, and the sixth detector 96 are selected as detection targets. Thus, only the second detector 92, the fourth detector 94, the fifth detector 95, and the sixth detector 96 are instructed to detect operation sound. In Operation S18B, the controller 121 acquires the second detection data 92D, the fourth detection data 94D, the fifth detection data 95D, and the sixth detection data 96D, and in Operation S18C, stores the second detection data 92D, the fourth detection data 94D, the fifth detection data 95D, and the sixth detection data 96D in the memory device 121c together with detection times. In Operation S18D, it is determined whether or not a temperature reduction/atmospheric exposure process has started. When the result of the determination is NO, the process returns to Operation S18B to repeat the above processes. In this way, the second detection data 92D, the fourth detection data 94D, the fifth detection data 95D, and the sixth detection data 96D are stored in the memory device 121c together with the detection times until the film processing is completed.

### (Temperature reduction and Atmospheric Exposure)

After a preset period of processing time has elapsed, an inert gas is supplied from the inert gas supply pipes 64c and 64d to the process chamber 22A so that the interior of the process chamber 57 is replaced with the inert gas, and the internal pressure of the process chamber 22A is returned to atmospheric pressure. In this specification, the term "preset period of processing time" used herein means a period of time during which the processing continues. This also applies to the following descriptions. In the temperature reduction/atmospheric exposure, the fan and the pump 112 in the blower box 114 become components serving as main sound sources.

In the sound data storage process, when it is determined in Operation S18D that the temperature reduction/atmospheric exposure process has started, a temperature reduction/atmospheric exposure sound process is started in Operation S20. In the temperature reduction/atmospheric exposure sound process, as shown in FIG. 6E, the second detector 92, the fourth detector 94, the fifth detector 95, the sixth detector 96, and the seventh detector 97 are selected as detection targets in Operation S20A. Thus, only the second detector 92, the fourth detector 94, the fifth detector 95, the sixth detector 96, and the seventh detector 97 are instructed to detect operation sound. In Operation S20B, the controller 121 acquires the second detection data 92D, the fourth detection data 94D, the fifth detection data 95D, the sixth detection data 96D, and the seventh detection data 97D, and in Operation S20C, stores the second detection data 92D, the fourth detection data 94D, the fifth detection data 95D, the sixth detection data 96D, and the seventh detection data 97D in the memory device 121c together with detection times. In Operation S20D, it is determined whether or not a boat unloading process has started. When the result of the determination is NO, the process returns to Operation S20B to repeat the above processes. In this way, the second detection data 92D, the fourth detection data 94D, the fifth detection data 95D, the sixth detection data 96D, and the seventh detection data 97D are stored in the memory device 121c together with the detection times until the temperature reduction/atmospheric exposure process is completed.

### (Boat Unloading)

Subsequently, the boat 34 is lowered by the boat elevator 35, the lower end of the manifold 26 is opened, and the processed wafers W held in the boat 34 are unloaded from the lower end of the manifold 26 to the transfer chamber 32 outside the reaction tube 22. During the boat unloading, the boat elevator 35 and the seal cap 25A become components serving as main sound sources.

In the sound data storage process, when it is determined in Operation S20D that the boat unloading process has started, a boat unloading sound process is started in Operation S22. In the boat unloading sound process, as shown in FIG. 6F, the second detector 92 and the third detector 93 are selected as detection targets in Operation S22A. Thus, only the second detector 92 and the third detector 93 are instructed to detect operation sound. In Operation S22B, the controller 121 acquires the second detection data 92D and the third detection data 93D, and in Operation S22C, stores the second detection data 92D and the third detection data 93D in the memory device 121c together with detection times. In Operation S22D, it is determined whether or not a wafer discharging process has started. When the result of the determination is NO, the process returns to Operation S22B to repeat the above processes. In this way, the second detection data 92D and the third detection data 93D are stored together with the detection times in the memory device 121c until the boat unloading process is completed.

### (Wafer Discharging)

The processed wafers W unloaded from the boat 34 are taken out by the transfer machine 38 and returned to an empty pod P that has been previously transferred onto the stage 45. A door is mounted to a wafer loading/unloading opening of the pod P. During the wafer discharging, the transfer machine 38 and the carrier loader 46 become components serving as main sound sources.

The pod P whose the wafer loading/unloading opening has been closed is transferred by the carrier loader 46 and delivered to a designated shelf 44A in the transfer chamber 42.

The pod P is temporarily stored in the shelf 44A, and the carrier loader 46 is returned from the shelf 44A to the load port 52 at a predetermined timing. The pod P accommodating the processed wafers W may be returned directly to the load port 52 without such a temporary storage. The pod P returned to the load port 52 is transferred to be subjected to a predetermined process.

In the sound data storage process, when it is determined in Operation S24 that the wafer discharging process has started, a wafer discharging sound process is executed in Operation S24. In the wafer discharging sound process, as shown in FIG. 6G, the first detector 91A, the first detector 91B, and the third detector 93 are selected as detection targets in Operation S24A. Thus, only the first detector 91A, the first detector 91B, and the third detector 93 are instructed to detect operation sound. In Operation S24B, the controller 121 acquires the first detection data 91AD, the first detection data 91BD, and the third detection data 93D, and in Operation S24C, stores the first detection data 91AD, the first detection data 91BD, and the third detection data 93D in the memory device 121c together with detection times. In Operation S24D, it is determined whether or not the wafer discharging process has been completed. When the result of the determination is NO, the process returns to Operation S24B to repeat the above processes. In this way, the first detection data 91AD, the first detection data 91BD, and the third detection data 93D are stored in the memory device 121c together with the detection times until the wafer charging process is completed. When the result of the determination in Operation S24D is YES, this process ends.

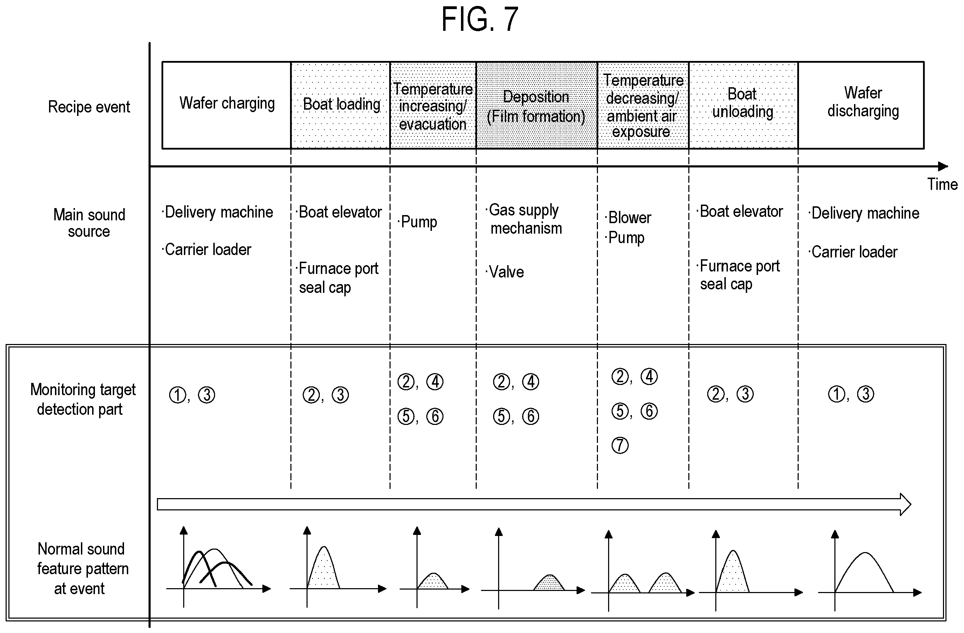

FIG. 7 shows a tabulated list chronologically showing the components serving as the main sound sources, the detection targets, and the corresponding reference sound data D for each of the above-described events. For example, in the wafer charging, the transfer machine 38 and the carrier loader 46 become components serving as the main sound sources, and the first detectors 91A and 91B and third detector 93 become the detection targets. The bottom row of the tabulated list shows the reference sound data obtained by integrating the pieces of data detected by the detection targets under normal conditions for each of the events.

The pieces of data stored in the memory device 121c in the sound data storage process is subjected to an abnormal sound check process to determine the presence or absence of an abnormality.

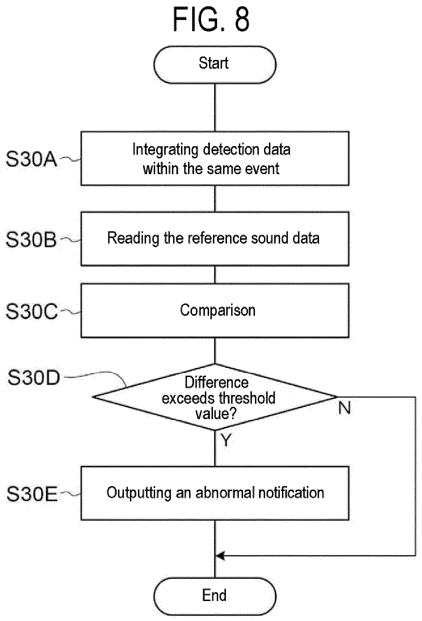

As shown in FIG. 8, the abnormal sound check process integrates pieces of detection data detected in the same event in Operation S30A. For example, in the event of the wafer charging process, the detected first detection data 91AD, first detection data 91BD, and third detection data 93D are integrated to generate integrated detection pattern data T.

Next, in Operation S30B, the reference sound data D corresponding to the same event is read out, and in Operation S30C, the integrated detection pattern data T is compared with the reference sound data D. In Operation S30D, it is determined whether or not a difference in the comparison exceeds a threshold value TH that defines a normal range. When the determination is YES, an abnormality notification is output in Operation S30E. The output of the abnormality notification may be executed by displaying the same on a display or the like.

Next, actions and effects obtained by the substrate processing apparatus 10 according to this embodiment will be described. According to this embodiment, one or more of the following effects may be obtained.
(1) According to the substrate processing apparatus 10 of this embodiment, at least one of the plurality of areas in which the operation sound is detected is selected to correspond to each of the plurality of operation events. Therefore, compared to a case where the operation sound is detected in all areas, the states of the components may be detected while reducing the processing performed in the controller 121 and reducing a load exerted on the CPU 121a.
(2) The detector is provided in at least one of the main housing 12 (a portion of the first area), the supply box 60 (a portion of the first area), the exhaust box 70 (a portion of the first area), the transfer section 40 (a portion of the second area which is also referred to as the second transfer area), or the transfer chamber 32 (a portion of the third area). Therefore, the state of the component in the area where the detector is provided may be detected.
(3) The second transfer area includes the shelf capable of holding the container and the lifter capable of raising and lowering the container to the position of the shelf. The third area includes the third transfer area in which the transfer machine capable of delivering the substrates to/from the second transfer area, and the boat lifter capable of raising and lowering the boat to be loaded into and unloaded from the process chamber are provided. The first area includes the first processing area in which the process chamber is provided, the second processing area in which the supply controller that controls the supply of the gas to the process chamber is provided, and the third processing area in which the exhaust controller that controls the exhaust of the gas from the process chamber is provided. Therefore, it is possible to detect the states of the components in at least each of the areas.
(4) The second transfer area and the third transfer area are provided in different closed spaces defined by the respective housings. Accordingly, it is possible to reduce the influence of the third transfer area and to easily detect sound in the second transfer area.
(5) The first processing area, the second processing area, and the third processing area are provided in different closed spaces defined by the respective housings. Therefore, when detecting sound in one of the first processing area, the second processing area, and the third processing area, it is possible to reduce the influence of the other areas and to easily detect an operating sound in a detection target area.
(6) The first area, the second area, and the third area are provided in different closed spaces defined by the respective housings. The fourth area in which at least a pump is provided is provided below the floor supporting the housings. The detector is provided in each of the first area, the second area, the third area, and the fourth area. Therefore, when detecting operating sound in one of the first area, the second area, the third area, and the fourth area, it is possible to reduce the influence of the other areas and to easily detect the operating sound in a detection target area.
(7) Since the plurality of detectors is provided inside the housing, even if the number of the housing or the component for which the operating sound is to be detected is large, the operating sound may be detected.
(8) The controller is configured not to receive data detected by a detector provided in an area that is not a detection target, or not to store the detection data in the memory after receiving the detection data. Therefore, compared to a case where an operating sound is detected by the detector provided in the area that is not a detection target and is stored, it is possible to reduce an amount of data stored and to reduce a capacity burden on the memory. Accordingly, even if the apparatus has a small storage capacity, the apparatus may continue to be operated.
(9) The controller is set to detect only the operation sound generated inside the area where the operation sound is to be detected among the plurality of areas. Therefore, it is possible to suppress unnecessary sound as noise from being detected in areas that are not detection targets, and to improve detection accuracy of the state of the component. In addition, compared to a case where operation sound is detected by detectors in the areas that are not detection targets and the detection data is sent to the controller, it is possible to reduce a network load. Accordingly, even if a network capacity of the apparatus is small, the apparatus may continue to be operated.
(10) The controller is set so as not to detect sound generated inside areas where operating sound is not detected among the plurality of areas. This may eliminate a need to perform preparation for operation sound detection, such as operating the detectors in the areas that are not detection targets. Accordingly, it is possible to reduce the burden exerted on the controller.
(11) The operation event is set for each operation type of the substrate processing apparatus. Accordingly, it is possible to detect the operating sound corresponding to each operation type. In other words, it is possible to detect the state of the component for each operation type.
(12) The detection data relating to the detected operating sound and the reference data which may be compared with the detection data are stored. The reference data is recorded for each operation type. Therefore, the detection data relating to the detected operating sound may be compared with the reference data for each operation type. Accordingly, the state of the component may be accurately checked for each operation type.
(13) The memory is provided to store the detection data relating to the detected operating sound and the reference data which may be compared with the detection data. Therefore, it is possible to prepare for the comparison of the detection data relating to the detected operating sound with the reference data for each operation type. Accordingly, it is possible to accurately check the state of the component for each operation type.
(14) The reference data is data learned by the machine learning. Therefore, even if the state of the component is changed according to an amount of usage, it is possible to extract reference data corresponding to such a change. Accordingly, it is possible to consistently maintain accurate reference data.
(15) The pattern representing the detection data is a pattern obtained by integrating pieces of detection information obtained in the plurality of areas for each operation event. Therefore, in a case in which a plurality of detection targets is provided, pieces of detection data are integrated for each operation event. This makes it possible to reduce the number of pieces of reference sound data to be stored, and to reduce a load exerted on the memory. Compared to a case of storing each pattern, it is possible to alleviate a capacity borne by the memory.
(16) The detection data may be arranged in a chronological order, and the pattern of the detection data in the chronological order may be compared with the pattern of the reference data. A time when abnormal sounds are generated at different locations may be specified, and a component that was operating at that time may be specified. Accordingly, it is possible to easily specify the time when the state of the component is changed.
(17) The pattern of the detection data is a pattern for each operation event and for each component. Accordingly, the state of each component used may be checked for each operation event.

In this embodiment, an unselected detector is set so as not to detect sound. Alternatively, data detected by the unselected detector may not be received, or even if such detection data is received, the detection data may not be stored in the memory. In other words, only data detected by a selected detector may be received, or only the data provided from the selected detector may be stored in the memory.

In addition, in the above, there has been described the example in which two detectors are provided in the second area and one detector is used in another area. However, the present disclosure is not limited thereto. The number of detectors may be set appropriately according to the type and number of detection targets and operations thereof.

### (Modifications)

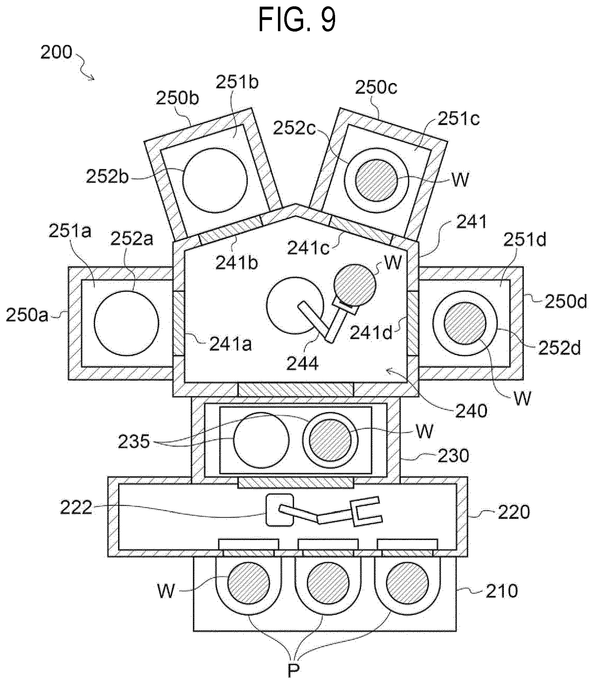

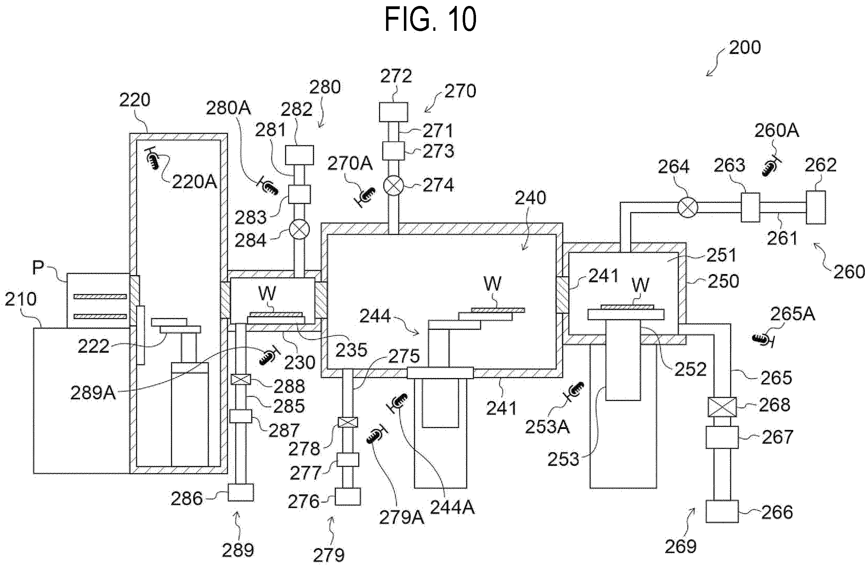

In the above-described embodiments, the vertical substrate processing apparatus has been described as an example. However, the present disclosure may also be applied to a single-substrate-type substrate processing apparatus 200 as shown in FIGS. 9 and 10.

The substrate processing apparatus 200 mainly includes a load port 210, an atmospheric transfer chamber 220, a load lock chamber 230, a vacuum transfer chamber 240, and a reactor 250 in which a process chamber is formed.

The load port 210 is provided on a front side (front surface side) of the substrate processing apparatus 200. The pod P is loaded onto and unloaded from the load port 210.

The atmospheric transfer chamber 220 is provided to be adjacent to the load port 210. An atmospheric transfer robot 222 that transfers a wafer W is provided in the atmospheric transfer chamber 220. A sound detector 220A that detects operation sound inside the atmospheric transfer chamber 220 is provided in the atmospheric transfer chamber 220.

The load lock chamber 230 is provided on a side facing the load port 210 in the atmospheric transfer chamber 220. The load lock chamber 230 is provided with at least two placement surfaces 235 on which the wafer W is placed.

A vacuum transfer chamber 240 is provided on a side facing the atmospheric transfer chamber 220 in the load lock chamber 230 to transfer the wafer W under a negative pressure. The vacuum transfer chamber 240 is formed inside a housing 241 and has a pentagonal shape in a plan view. The load lock chamber 230 and the reactors 250 (250a to 250d) for processing the wafer W are connected to each side of the pentagon. Hereinafter, the four reactors 250a, 250b, 250c, and 250d may be collectively referred to as the reactor 250. A transfer robot 244 as a transferor for delivering (transferring) the wafer W under the negative pressure is provided approximately at the center of the vacuum transfer chamber 240. A sound detector 244A for detecting operation sound from the transfer robot 244 is provided near the transfer robot 244.

A process chamber 251 is formed inside each of the reactors 250. A support table 252 for supporting the wafer W and an elevator 253 for raising and lowering the support table 252 is provided inside each process chamber 251. A sound detector 253A for detecting operating sound from the elevator 253 is provided near the elevator 253. Between each process chamber 251 and the vacuum transfer chamber 240, the wafer W is transferred by the transfer robot 244 via gate valves 241 (241a to 241d).

As shown in FIG. 10, a gas used for the substrate processing is supplied into the process chamber 251 by a gas supply mechanism 260 serving as a supply control system. The gas supply mechanism 260 includes a gas pipe 261 connected to the process chamber 251 of the reactor 250. A gas source 262, an MFC 263, and a valve 264 are connected to the gas pipe 261 sequentially from an upstream side. A sound detector 260A that detects operation sound from the gas supply mechanism 260 is provided near the gas supply mechanism 260.

An exhaust pipe 265 is connected to the process chamber 251. A valve 268, an APC valve 267, and a vacuum pump 266 are connected to the exhaust pipe 265. With this configuration, the gas may be discharged from the process chamber 251, and an internal pressure of the process chamber 251 may be set to a processing pressure adapted for processing. An exhaust control system 269 is mainly composed of the exhaust pipe 265, the valve 268, the APC valve 267, and the vacuum pump 266. A sound detector 269A that detects operation sound from the exhaust control system 269 is provided near the exhaust control system 269.

A gas is supplied into the vacuum transfer chamber 240 by a gas supply mechanism 280 serving as a supply control system. The gas supply mechanism 270 includes a gas pipe 271 connected to the vacuum transfer chamber 240. A gas source 272, an MFC 273, and a valve 274 are connected to the gas pipe 271 sequentially from an upstream side. A sound detector 270A that detects operating sound from the gas supply mechanism 270 is provided near the gas supply mechanism 270.

An exhaust pipe 275 is connected to the load lock chamber 230. A valve 278, an APC valve 277, and a vacuum pump 276 are connected to the exhaust pipe 275. With this configuration, the gas may be discharged from the vacuum transfer chamber 240 so that an internal pressure of the vacuum transfer chamber 240 may be set to a processing pressure adapted for processing. An exhaust control system 279 is mainly composed of the exhaust pipe 275, the valve 278, the APC valve 277, and the vacuum pump 276. A sound detector 279A that detects operating sound from the exhaust control system 279 is provided near the exhaust control system 279.

A gas is supplied into the load lock chamber 230 by a gas supply mechanism 280 serving as a supply control system. The gas supply mechanism 280 includes a gas pipe 281 connected to the load lock chamber 230. A gas source 282, an MFC 283, and a valve 284 are connected to the gas pipe 281 sequentially from an upstream side. A sound detector 280A that detects operating sound from the gas supply mechanism 280 is provided near the gas supply mechanism 280.

An exhaust pipe 285 is connected to the load lock chamber 230. A valve 288, an APC valve 287, and a vacuum pump 286 are connected to the exhaust pipe 285. With this configuration, the gas may be discharged from the load lock chamber 230 so that an internal pressure of the load lock chamber 230 may be set to a processing pressure adapted for processing. An exhaust control system 289 is mainly composed of the exhaust pipe 285, the valve 288, the APC valve 287, and the vacuum pump 286. A sound detector 289A that detects an operating sound from the exhaust control system 289 is provided near the exhaust control system 289.

Even in the substrate processing apparatus 200, like the substrate processing apparatus 10, reference sound data D2 corresponding to each operation event is stored in the memory device 121c of the controller 121. In addition, a sound detector to be selected in association with each operation event executed in the substrate processing apparatus 200 is stored in the memory device 121c.

Even in the substrate processing apparatus 200 according to the modification, like the substrate processing apparatus 10, pieces of detection data from the sound detector selected for each operation event is stored together in a chronological order. Even in the substrate processing apparatus 200, one or more effects similar to those of the substrate processing apparatus 10 may be obtained.

For example, in the above-described embodiments, as an example, a process such as forming a silicon-containing film such as a SiN film or a SiO film may be performed in the process chamber 22A. However, the present disclosure is not limited to such an embodiment. For example, the present disclosure may also be suitably applied to a case where a film containing a metal element such as titanium (Ti), zirconium (Zr), hafnium (Hf), tantalum (Ta), niobium (Nb), aluminum (Al), molybdenum (Mo), tungsten (W), or the like, that is, a metal-based film, is formed on the wafer W.

That is, the present disclosure may be suitably applied to a case where a film containing a predetermined element such as a semiconductor element or a metal element is formed. However, the present disclosure may also be suitably applied to a case where processes such as an oxidation process, a diffusion process, an annealing process, an etching process, and the like are performed on a film formed on the wafer W.

Further, the present disclosure is not limited to a semiconductor manufacturing apparatus that processes semiconductor wafers, such as the substrate processing apparatus 10 according to this embodiment. However, the present disclosure may also be applied to an LCD (Liquid Crystal Display) manufacturing apparatus that processes glass substrates.

According to the present disclosure in some embodiments, it is possible to easily detect a state of a component.

While certain embodiments have been described, these embodiments have been presented by way of example only, and are not intended to limit the scope of the disclosures. Indeed, the embodiments described herein may be embodied in a variety of other forms. Further, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus, comprising:
a process chamber configured to process a substrate;
a transferor configured to transfer the substrate;
a component relating to at least one of the process chamber or the transferor;
a memory storing a plurality of operation events;
a plurality of areas in each of which at least one of the process chamber, the transferor, or the component is provided;
a detector provided in at least one of the plurality of areas and configured to be capable of detecting an operating sound of the component; and
a controller configured to be capable of controlling the component and the detector to select one area of the plurality of areas, which corresponds to each of the plurality of operation events, and to acquire detection data from the detector provided in the selected one area.

2. The substrate processing apparatus of Claim 1, wherein the plurality of areas includes:
a first area in which at least the process chamber is provided;
a second area in which at least a first transferor of the transferor, which is capable of transferring the substrate, is provided; and
a third area in which a second transferor of the transferor, which is capable of moving the substrate between the first area and the second area, is provided.

3. The substrate processing apparatus of Claim 2, wherein the second area includes a second transfer area in which a shelf capable of holding a container and an elevator capable of raising and lowering the container to a position of the shelf are provided,
wherein the third area includes a third transfer area in which a transfer machine capable of delivering the substrate to and from the second transfer area, and a boat elevator capable of raising and lowering a boat which is loaded into and unloaded from the process chamber are provided, and
wherein the first area includes a first processing area in which the process chamber is provided, a second processing area in which a supply controller configured to control a supp ly of a gas to the process chamber is provided, and a third processing area in which an exhaus t controller configured to control an exhaust of the gas from the process chamber is provided.

4. The substrate processing apparatus of Claim 3, wherein the second transfer area and the third transfer area are provided in different closed spaces defined by different housings, respectively.

5. The substrate processing apparatus of Claim 3 or 4, wherein the first processing area, the second processing area, and the third processing area are provided in different closed spaces defined by different housings, respectively.

6. The substrate processing apparatus of any one of Claims 2 to 5, wherein the first area, the second area, and the third area are provided in different closed spaces defined by different housings, respectively,
wherein a fourth area in which at least a pump is provided is further provided below a floor supporting the different housings, and
wherein the detector is provided in each of the first area, the second area, the third area, and the fourth area.

7. The substrate processing apparatus of any one of Claims 1 to 6, wherein the controller is configured to be capable of not receiving detection data from the detector corresponding to an area which is not a detection target, or not storing the detection data in the memory after receiving the detection data.

8. The substrate processing apparatus of any one of Claims 1 to 7, wherein the controller is configured to be capable of setting the detector to detect only sound generated inside an area in which the operating sound is to be detected, among the plurality of areas.

9. The substrate processing apparatus of any one of Claims 1 to 8, wherein the plurality of operation events is set for each operation type of the substrate processing apparatus.

10. The substrate processing apparatus of Claim 9, wherein detection data relating to the detected operating sound and reference data which is capable of being compared with the detection data are stored, and the reference data is recorded for each operation type.

11. The substrate processing apparatus of any one of Claims 1 to 10, wherein a pattern representing the detection data is obtained by integrating pieces of detection information obtained in the plurality of the areas for each of the plurality of operation events.

12. The substrate processing apparatus of Claim 11, wherein the memory stores the detection data relating to the detected operating sound and reference data which is capable of being compared with the detection data,
wherein the detection data is arranged in a chronological order, and
wherein the pattern of the detection data in the chronological order is compared with a pattern of the reference data, different locations in the comparison are specified as a time at which an abnormal sound was generated, and the component that was operating at the time is specified.

13. A detection method, comprising:
selecting, from a plurality of areas in each of which at least one of a process chamber, a transferor, or a component is provided, at least one area corresponding to each of a plurality of operation events; and
acquiring data about an operating sound of the component, which is detected by a detector in the selected at least one area.

14. A method of manufacturing a semiconductor device, the method comprising:
the detection method of Claim 13;
processing a substrate.

15. A program that causes, by a computer, a substrate processing apparatus to perform a process comprising:
selecting, from a plurality of areas in each of which at least one of a process chamber, a transferor, or a component is provided, at least one area corresponding to each of a plurality of operation events; and
acquiring data about an operating sound of the component, which is detected by a detector in the selected at least one area.
